# EUROPEAN PATENT APPLICATION

(11) **EP 4 137 832 A1**
(43) Date of publication of application: **22.02.2023**
(21) Application number: 21788335.4
(22) Date of filing: 12.04.2021
(51) Int. Cl.: G01R 33/02, A61B 5/06, A61B 1/04

(54) **METHOD AND APPARATUS FOR ESTABLISHING EFFECTIVE MAGNETIC CONNECTION**

(30) Priority: 13.04.2020 CN 202010283807
(71) Applicant: Beijing Institute Of Technology, Beijing 100081 (CN)
(72) Inventor: HUANG, Qiang, Beijing 100081 (CN); LI, Jing, Beijing 100081 (CN); ZHANG, Weimin, Beijing 100081 (CN); ZHOU, Jiyang, Beijing 100081 (CN); DARIO, Paolo, Beijing 100081 (CN); CIUTI, Gastone, Beijing 100081 (CN); ZHANG, Wenhui, Beijing 100081 (CN); WANG, Yanling, Beijing 100081 (CN)
(74) Representative: Vidon Brevets & Stratégie
(86) International application number: PCT/CN2021/086599
(87) International publication number: WO 2021/208849

(57) **Abstract**

The present invention discloses a method for establishing an effective magnetic connection. The method includes a step of effective magnetic connection judgment and a step of effective magnetic connection establishment. When the effective magnetic connection is established, one of the following manners is adopted: Manner 1 is performing searching on planes with different heights, and finding a position where a greatest magnetic field value meets a magnetic field establishment threshold of the effective magnetic connection in the planes to establish the effective magnetic connection; Manner 2 is finding the position where the greatest magnetic field value meets the magnetic field establishment threshold of the effective magnetic connection according to a solution of performing searching in a local space to establish the effective magnetic connection; and Manner 3 is directly moving an auxiliary magnetic sensor array to a position with a relative distance meeting Δd to establish the connection. The present invention further provides an apparatus for establishing an effective magnetic connection. The use of the present invention can ensure that a mobile magnetic source is always in a range of being effectively driven and detected during movement in a large working space.

## Description

### TECHNICAL FIELD

The present invention relates to the technical field of driving and detection of a mobile magnetic source, in particular to a method and apparatus for establishing an effective magnetic connection.

### BACKGROUND

When a driving magnet (also referred to as an external magnet) drives a capsule robot (a mobile magnetic source), it is necessary to accurately detect the position of the capsule robot. The premise that the capsule robot may be effectively driven and detected is that the driving magnet used for driving or a magnetic sensor used for detection has an effective magnetic connection with the capsule robot in which a magnetic source is embedded. If the mobile magnetic source moves beyond the range that may be effectively detected in a working space, or the mobile magnetic source needs to be magnetically disconnected from the external magnet many times in the moving process, it is necessary to establish the effective magnetic connection between the mobile magnetic source and the external magnet, so the mobile magnetic source may be effectively driven and detected.

### SUMMARY

In view of this, the present invention provides a method and apparatus for establishing an effective magnetic connection between a mobile magnetic source and an external magnet. It may be ensured that the mobile magnetic source is always within a range of being effectively driven and detected during movement in a large working space. The technical solution is applied to a scene where a pose of the mobile magnetic source is detected by a magnetic sensor array fixedly connected with the external magnet.

In order to solve the above technical problems, the present invention is implemented as follows.

A method for establishing an effective magnetic connection is suitable for a case where a driving magnet and a magnetic sensor array are fixedly connected and a movement guide module is connected with the driving magnet and the magnetic sensor array for movement; and the method includes a step of effective magnetic connection judgment and a step of effective magnetic connection establishment.

The effective magnetic connection judgment is: judging whether the effective magnetic connection has been established according to the magnetic field signal intensity of a mobile magnetic source or a relative distance Δd between the mobile magnetic source and the movement guide module; and
the effective magnetic connection establishment is: establishing the connection in one of the following manners.

Manner 1: dividing a motion space of the driving magnet into a plurality of height planes, searching for magnetic fields in the same height plane, and if a greatest magnetic field value meets a magnetic field establishment threshold of the effective magnetic connection, establishing the effective magnetic connection; and if not, searching for magnetic fields in another height plane until the condition is met; Manner 2: obtaining magnetic fields at different positions in a local space, if a greatest magnetic field value meets the magnetic field establishment threshold of the effective magnetic connection, establishing the effective magnetic connection; and if not, changing the local space according to conditions, and performing judgment again until the condition is met; and

Manner 3: using an auxiliary magnetic sensor array to obtain a position of the mobile magnetic source through detection, determining a target position of the movement guide module according to requirements for the relative distance Δd between the mobile magnetic source and the movement guide module, and moving the movement guide module to the target position to establish the effective magnetic connection.

Preferably, the manner of judging whether the effective magnetic connection has been established according to the magnetic field signal intensity of the mobile magnetic source is: collecting, by the magnetic sensor array, magnetic field signals of the mobile magnetic source, and if a magnetic field signal collected by a designated magnetic sensor in the magnetic sensor array is greater than a set magnetic field threshold of the effective magnetic connection, determining that the effective magnetic connection has been established; or, determining that the effective magnetic connection has not been established; and
the manner of judging whether the effective magnetic connection has been established according to the relative distance between the mobile magnetic source and the movement guide module is: detecting the relative distance between the mobile magnetic source and the movement guide module, and if the relative distance is less than a set relative distance threshold, determining that the effective magnetic connection has been established; or, determining that the effective magnetic connection has not been established.

Preferably, Manner 1 is specifically:
Step a1, with a position where the magnetic sensor array is located currently as a searching center, establishing a plane region under a current height and with a set side length value as a searching region; designating a plurality of positions as designated sampling positions of the magnetic sensor array; and selecting a magnetic sensor A in the magnetic sensor array, and using a magnetic field signal collected by the magnetic sensor A as a signal source;
Step a2, using the movement guide module to drive the magnetic sensor array to move, so the magnetic sensor A sequentially collects magnetic field signals at the designated sampling positions; and
Step a3, comparing magnetic field signal moduli collected by the magnetic sensor A at all the designated sampling positions in the current searching region; if all the moduli are less than a set magnetic field modulus threshold, decreasing a height of the searching plane, returning to Step a2 and searching again; or driving, by the movement guide module, the magnetic sensor array to move, so the magnetic sensor A moves to a sampling position where a greatest magnetic field signal modulus appears, that is, the effective magnetic connection is established.

Preferably, Manner 2 is specifically:
Step b1, selecting M magnetic sensors for searching in the magnetic sensor array, and collecting magnetic field signals at a current position of the magnetic sensor array, wherein M is an integer greater than or equal to 2;
Step b2: determining a target displacement increment of the magnetic sensor array according to the collected magnetic field signals, wherein the target displacement increment is that a position of a magnetic sensor X in the M magnetic sensors points to a position of a magnetic sensor Y in the M magnetic sensors, and the magnetic sensor Y is the one that obtains a greatest magnetic field signal in the M magnetic sensors;
Step b3, with the position where the magnetic sensor array is located currently as a start point, using the guide module to drive the magnetic sensor array to move according to the target displacement increment, so the magnetic sensor X moves to the position of the magnetic sensor Y, thereby reaching the target position; and
Step b4, performing the effective magnetic connection judgment based on the magnetic field signal intensity of the magnetic sensor X; if the effective magnetic connection has been established, stopping moving the magnetic sensor array; and if the effective magnetic connection has not been established, with the current target position as a start point, returning to Step b2 and performing searching again until the effective magnetic connection is established.

Preferably, a determining manner of the target displacement increment is:
selecting one magnetic sensor in the M magnetic sensors, and if a magnetic field signal modulus of the selected magnetic sensor is not the greatest, taking the magnetic sensor as the magnetic sensor X and a current position of the magnetic sensor as an initial position of a basic displacement increment; selecting the magnetic sensor Y, having a greatest magnetic field signal modulus, in the M magnetic sensors, and taking a current position where the magnetic sensor Y is located as an end position of the basic displacement increment; taking a vector pointing from the initial position of the basic displacement increment to the end position of the basic displacement increment as the basic displacement increment, and multiplying a positive adjustable coefficient by the basic displacement increment to obtain the target displacement increment; if the magnetic field signal modulus of the selected magnetic sensor is the greatest, using the magnetic sensor as the magnetic sensor Y and determining a magnetic sensor with a smallest magnetic field signal modulus as the magnetic sensor X; taking the current position where the magnetic sensor Y is located as the initial position of the basic displacement increment, and the current position where the magnetic sensor X is located as the end position of the basic displacement increment, taking the vector pointing from the initial position of the basic displacement increment to the end position of the basic displacement increment as the basic displacement increment, and multiplying a negative adjustable coefficient by the basic displacement increment to obtain the target displacement increment; or
obtaining an average value of the magnetic field signals collected by all the magnetic sensors in the M magnetic sensors; selecting a magnetic sensor, with a magnetic field signal the closest to the obtained average value of the magnetic field signals, in the M magnetic sensors, recording the magnetic sensor as the magnetic sensor X, and taking the current position of the magnetic sensor X as the initial position of the basic displacement increment; selecting the magnetic sensor Y, having the greatest magnetic field signal modulus, in the M magnetic sensors, and taking the current position where the magnetic sensor Y is located as the end position of the basic displacement increment; and taking the vector pointing from the initial position of the basic displacement increment to the end position of the basic displacement increment as the basic displacement increment, and multiplying the positive adjustable coefficient by the basic displacement increment to obtain the target displacement increment.

Preferably, the effective magnetic connection judgment is performed periodically, and when it is determined that the effective connection has not been established, the effective magnetic connection establishment operation is performed.

The invention further provides an apparatus for establishing an effective magnetic connection. The apparatus for establishing the effective magnetic connection is suitable for a case where a driving magnet is fixedly connected with a magnetic sensor array and a movement guide module is connected with the driving magnet and the magnetic sensor array for movement. The apparatus includes an effective magnetic connection judgment unit, an effective magnetic connection establishment unit, a magnetic sensor array signal obtaining unit and the movement guide module.

The magnetic sensor array signal obtaining unit is configured to obtain magnetic field signals collected by the magnetic sensor array, and send the magnetic field signals to the effective magnetic connection judgment unit and the effective magnetic connection establishment unit;
the movement guide module is configured to drive the driving magnet and the magnetic sensor array fixedly connected with the driving magnet to move according to movement requirements provided by the effective magnetic connection establishment unit;
the effective magnetic connection judgment unit is configured to judge whether the effective magnetic connection has been established according to the magnetic field signal intensity of a mobile magnetic source or a relative distance Δd between the mobile magnetic source and the movement guide module;
the effective magnetic connection establishment unit includes a first establishment module and a second establishment module, and one of them is chosen for use:
   the first establishment module divides a motion space of the driving magnet into a plurality of height planes, drives the magnetic sensor array to move through the movement guide module, searches for magnetic fields in the same height plane, and if a greatest magnetic field value meets a magnetic field establishment threshold of the effective magnetic connection, establishes the effective magnetic connection; and if not, searches for magnetic fields in another height plane until the condition is met; and the second establishment module obtains magnetic fields at different positions in a local space through the magnetic field signals collected by the magnetic sensor array, and if a maximum magnetic field value meets the magnetic field establishment threshold of the effective magnetic connection, establishes the effective magnetic connection; and if not, drives the magnetic sensor array to move through the movement guide module, changes a position of the local space according to conditions, and performs judgment again until the condition is met.

Preferably, the apparatus further includes an auxiliary magnetic sensor array.

The effective magnetic connection establishment unit further includes a third establishment module configured to obtain a position of the mobile magnetic source according to detection of the auxiliary magnetic sensor array, determine a target position of the movement guide module according to requirement of the relative distance Δd between the mobile magnetic source and the movement guide module, and move the movement guide module to the target position to establish the effective magnetic connection; and one of the first establishment module, the second establishment module, and the third establishment module is selected for use.

Preferably, a process that the first establishment module performs searching according to height planes and establishes the connection is as follows:
with a position where the magnetic sensor array is located currently as a searching center, establishing a plane region under a current height and with a set side length value as a searching region; designating a plurality of positions as designated sampling positions of the magnetic sensor array; and selecting a magnetic sensor A in the magnetic sensor array, and using a magnetic field signal collected by the magnetic sensor A as a signal source;
using the movement guide module to drive the magnetic sensor array to move, so the magnetic sensor A sequentially collects magnetic field signals at the designated sampling positions; and
comparing magnetic field signal moduli collected by the magnetic sensor A at all the designated sampling positions in the current searching region; if all the moduli are less than a set magnetic field modulus threshold, decreasing a height of the searching plane, and searching again; or driving, by the movement guide module, the magnetic sensor array to move, so the magnetic sensor A moves to a sampling position where a greatest magnetic field signal modulus appears, that is, the effective magnetic connection is established.

Preferably, a process that the second establishment module performs searching according to a local region and establishes the connection is as follows:
selecting M magnetic sensors for searching in the magnetic sensor array, and obtaining magnetic field signals collected at a current position of the magnetic sensor array through the magnetic sensor array signal obtaining unit, wherein M is an integer greater than or equal to 2;
determining a target displacement increment of the magnetic sensor array according to the collected magnetic field signals, wherein the target displacement increment is that a position of a magnetic sensor X in the M magnetic sensors points to a position of a magnetic sensor Y in the M magnetic sensors; and the magnetic sensor Y is the one that obtains a greatest magnetic field signal in the M magnetic sensors;
with the position where the magnetic sensor array is located currently as a start point, using the movement guide module to drive the magnetic sensor array to move according to the target displacement increment, so the magnetic sensor X moves to the position of the magnetic sensor Y, thereby reaching the target position; and
performing effective magnetic connection judgment based on the magnetic field signal intensity of the magnetic sensor X; if the effective magnetic connection has been established, stopping moving the magnetic sensor array; and if the effective magnetic connection has not been established, with the current target position as a start point, performing searching again until the effective magnetic connection is established.

Beneficial effects:
(1) The effective magnetic connection establishment solution provided by the present invention can ensure that the mobile magnetic source is always within the range of being effectively driven and detected during movement in the large working space.
(2) Through periodic effective magnetic connection detection, it can be ensured that the magnetic connection is always effective.
(3) The method of traversing and searching the sampling position of the maximum signal source by using a fixed magnetic sensor can directly converge to the maximum magnetic field value of the magnetic fields in the same plane, and finally find an optimal solution.
(4) The method of using the plurality of magnetic sensors to progressively search for the sampling position of the maximum signal source can directly converge to the maximum magnetic field value in the local space. In the same local space, the movement guide module does not need to move multiple times, and moves only when from one optimal solution to another optimal value. Each time the movement guide module moves to the optimal magnetic field direction, and the efficiency is high.
(5) The method of using the auxiliary magnetic sensor array to search for the position of the mobile magnetic source can directly find the position to establish the magnetic connection, and then the magnetic connection is directly established.

### BRIEF DESCRIPTION OF THE DRAWINGS

Fig. 1 is a schematic diagram of a detection sensor array; (a) is a magnetic sensor array, and (b) is an auxiliary magnetic sensor array; and 1-driving magnet, and 2-magnetic sensor chip in the magnetic sensor array.
Fig. 2 is a flowchart of a method of the present invention.
Fig. 3 is a schematic diagram of a traversal searching method.
Fig. 4 is a schematic diagram of a progressive searching method; and 3-initial position of a basic displacement increment, namely, a position of a magnetic sensor X, and 4-end position of the basic displacement increment, namely, a position of a magnetic sensor Y
Fig. 5 is a schematic diagram of an apparatus for establishing an effective magnetic connection according to the present invention.

### DETAILED DESCRIPTION

The present invention will be described in detail below with reference to the accompanying drawings and embodiments.

A solution for establishing an effective magnetic connection provided by the present invention refers to establishing an effective connection between a driving magnet and a mobile magnetic source. The mobile magnetic source is composed of small magnets, cameras and other functional components, which move in a working environment to complete a task of checking the working environment, such as a capsule robot. The driving magnet refers to another magnet that drives the mobile magnetic source. The driving magnet is driven by a movement guide module to achieve spatial displacement. By detecting magnetic field signals by a magnetic sensor array, a position and posture of the mobile magnetic source may be obtained.

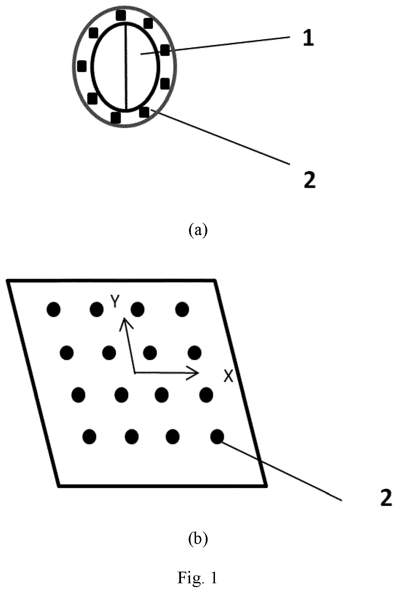

The present invention is suitable for a case where the driving magnet is fixedly connected with the magnetic sensor array, and the movement guide module is connected with the driving magnet and the magnetic sensor array for movement. As shown in Fig. 1(a), the driving magnet and the magnetic sensor array are fixedly connected together through a disc-shaped structure. The driving magnet 1 is disposition and postured in the middle of a connecting disc, and a magnetic sensor chip 2 surrounds the driving magnet 1. Signals of the magnetic sensor array may be identified and used only by a signal processing circuit. The signal processing circuit in the present invention may be disposition and postured together with the magnetic sensor array and move synchronously with the driving magnet. But in fact, the signal processing circuit and the magnetic sensor array may also be set separately and connected by wireless communications. Since the present invention does not involve the improvement of the signal processing circuit, no matter what form or position relationship the signal processing circuit exists in, it is not limited. It only requires that magnetic sensors and the driving magnet are fixedly connected, and the magnetic sensor array and the driving magnet move synchronously.

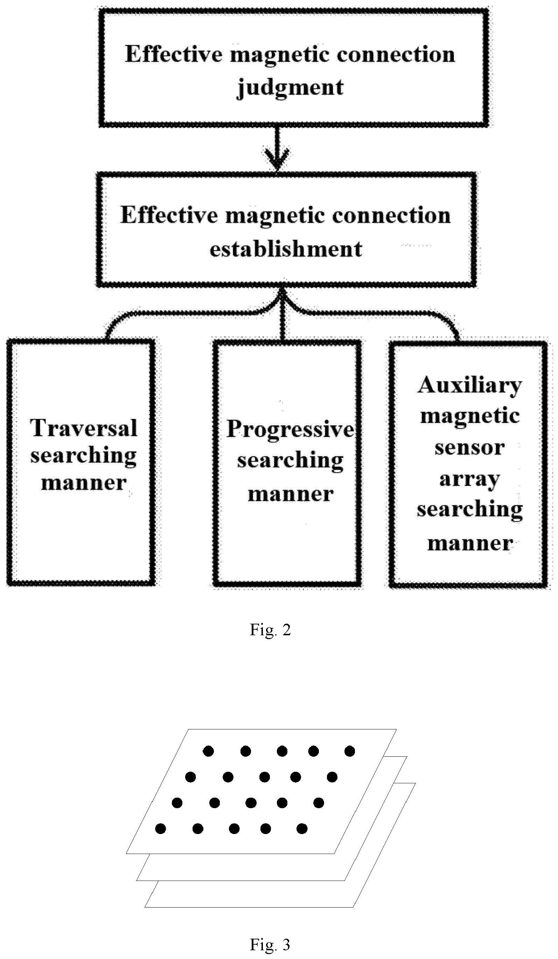

Fig. 2 shows a schematic diagram of a method for establishing an effective magnetic connection according to the present invention. As shown in the figure, the method includes a step of effective magnetic connection judgment and a step of effective magnetic connection establishment. In actual application, the effective magnetic connection judgment operation may be performed before the driving magnet starts to work. The effective magnetic connection judgment operation may also be periodically performed in the working process of the driving magnet. If it is determined that the connection is not established, the effective magnetic connection establishment operation is performed. The effective magnetic connection establishment operation may also be executed once at the beginning each time the driving magnet starts to work.

A manner of the effective magnetic connection judgment is: whether the effective magnetic connection has been established is judged according to the magnetic field signal intensity of the mobile magnetic source or a relative distance Δd between the mobile magnetic source and the movement guide module.

When judgment is performed according to the magnetic field signal intensity: after the driving magnet is installed, in the movement process of the mobile magnetic source, a total magnetic field measured by each magnetic sensor is collected, an effective magnetic field signal is obtained by subtracting an initial fixed offset magnetic field B̅_{bos} of the magnetic sensors, a fixed offset magnetic field B̅_{boe} of the driving magnet and an ambient magnetic field B̅ₑₜₕ at a position where each magnetic sensor is located from the total magnetic field, and the signal is the magnetic field signal of the mobile magnetic source. A magnetic field signal of the mobile magnetic source collected by one of the magnetic sensors is utilized for judgment. If the magnetic field signal is greater than a set threshold, for example, the threshold is set to be about 1 Gs, the effective magnetic connection is established; or, the effective magnetic connection is not established.

When the judgment is performed according to the relative distance: the magnetic sensor array or an auxiliary magnetic sensor array with a larger detection range is used to perform position and posture detection to obtain the position of the mobile magnetic source, and then the relative distance information Δd between the mobile magnetic source and the movement guide module is calculated. If the relative distance Δd between the mobile magnetic source and the movement guide module is less than a set relative distance threshold, for example, 20 cm, the effective magnetic connection is established; or, the effective magnetic connection is not established.

There are three manners to establish the effective magnetic connection, that is, a) a manner of adopting a fixed magnetic sensor to traverse and search for a greatest signal source sampling position; b) a manner of adopting a plurality of magnetic sensors to progressively search for the greatest signal source sampling position; and c) a manner of adopting an auxiliary magnetic sensor array to search for the position of the mobile magnetic source.

Among them, a) and b) are both spatial searching manners. An array fixedly connected to the driving magnet is used, and different methods are adopted to search for a greatest magnetic field value. A manner of obtaining data is simple and the amount of calculation is small. When a condition is met, it is considered that the magnetic connection is established.

A detailed description is given below for each manner.

### a) The manner of adopting the fixed magnetic sensor to traverse and search for the greatest signal source sampling position

In this manner, a motion space of the driving magnet is divided into a plurality of height planes, magnetic fields in the same height plane are searched, and if a greatest magnetic field value meets a magnetic field establishment threshold of the effective magnetic connection, the effective magnetic connection is established; and if not, magnetic fields in another height plane are searched until the condition is met. The advantage of this manner is that it can directly converge to the greatest magnetic field value of the magnetic fields in the same plane, and finally find an optimal solution.

The specific implementation process of this manner is:

Step a1, with a position where the magnetic sensor array is located currently as a searching center, a plane region under a current height and with a set side length value is established as a searching region, for example, a plane as shown in Fig. 3; and a plurality of positions are designated as designated sampling positions of the magnetic sensor array in advance. The designated positions may adopt matrix arrangement as shown in Fig. 3, and such traversal is more regular, and is conducive to finding an optimal signal point. A row spacing and a column spacing of the matrix arrangement may both be set to be 10 cm. A magnetic sensor A is selected in the magnetic sensor array, and a magnetic field signal collected by the magnetic sensor A is taken as a signal source.

Step a2, the movement guide module is used to drive the magnetic sensor array to move, so the magnetic sensor A sequentially collects magnetic field signals at each sampling position as shown in Fig. 3.

Step a3, magnetic field signal moduli collected by the magnetic sensor A at all the designated sampling positions in the current searching region are compared. If all the moduli are less than a set magnetic field modulus threshold, it is considered that a current height distance is too far, and the height of the searching plane is decreased towards the mobile magnetic source, for example, heights shown in Fig. 3, it returns to Step a2 and searching is performed again. Or, the movement guide module drives the magnetic sensor array to move, so the magnetic sensor A moves to a sampling position where a greatest magnetic field signal modulus appears, that is, the effective magnetic connection is established.

### b) The manner of adopting the plurality of magnetic sensors to progressively search for the greatest signal source sampling position

In this manner, magnetic fields at different positions in a local space are obtained first, if a greatest magnetic field value meets the magnetic field establishment threshold of the effective magnetic connection, the effective magnetic connection is established; and if not, the local space is changed according to conditions, and judgment is performed again until the condition is met. The advantage of this manner is that it directly converges to a greatest magnetic field value in the local space. In the same local space, the movement guide module does not need to move multiple times, and moves only when from one optimal solution to another optimal value. Each time the movement guide module moves to an optimal magnetic field direction, and the efficiency is high.

The specific implementation process of this manner is:
Step b1, M magnetic sensors for searching in the magnetic sensor array are selected, for example, M=36. Magnetic field signals are collected at a current position of the magnetic sensor array.
Step b2: a target displacement increment of the magnetic sensor array is determined according to the collected magnetic field signals. The target displacement increment is a spatial vector pointing from a position of a magnetic sensor X to a position of a magnetic sensor Y The magnetic sensor X is the selected sensor in the 36 magnetic sensors. The magnetic sensor Y is the one that obtains a greatest magnetic field signal in the 36 magnetic sensors.
Step b3, with the position where the magnetic sensor array is located currently as a start point, the guide module is used to drive the magnetic sensor array to move according to the target displacement increment, so the magnetic sensor X moves to the position of the magnetic sensor Y, thereby reaching the target position.
Step b4, the effective magnetic connection judgment is performed based on the magnetic field signal intensity of the magnetic sensor X. If the effective magnetic connection has been established, the magnetic sensor array stops moving. If the effective magnetic connection has not been established, with the current target position as a start point, it returns to Step b2 and searching is performed again until the effective magnetic connection is established.

In the above steps, there are two manners to determine the target displacement increment.

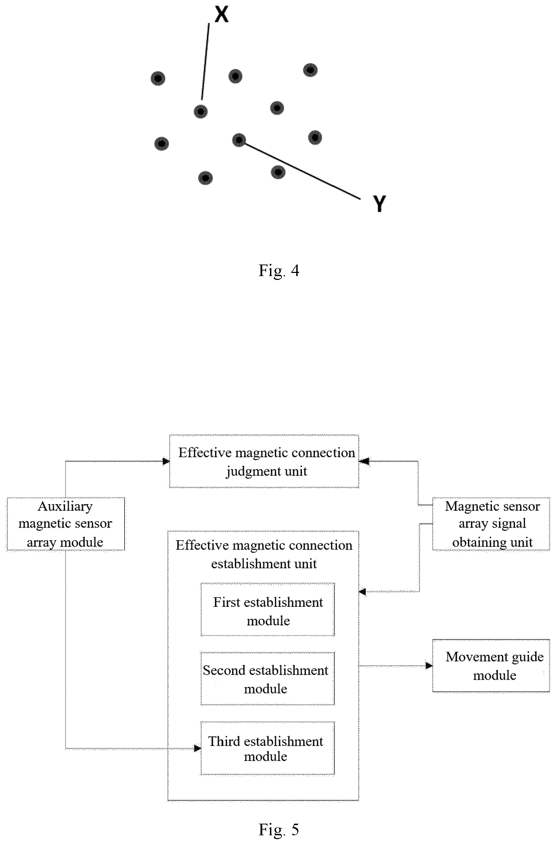

Manner 1, one magnetic sensor in the 36 magnetic sensors is selected, and if a magnetic field signal modulus of the selected magnetic sensor is not the greatest, the magnetic sensor is taken as the magnetic sensor X and a current position of the magnetic sensor is taken as an initial position of a basic displacement increment, referring to X in Fig. 4. The magnetic sensor Y, having a greatest magnetic field signal modulus, in the 36 magnetic sensors is selected, and a current position where the magnetic sensor Y is located is taken as an end position of the basic displacement increment, referring to Y in Fig. 4. A vector pointing from the initial position of the basic displacement increment to the end position of the basic displacement increment is taken as the basic displacement incremen :Δ̅ϕ̅_{base1} t, and a positive adjustable coefficient a is multiplied by the basic displacement increment to obtain the target displacement increment :Δ̅ϕ̅₁, wherein Δ̅ϕ̅₁ = a × Δ̅ϕ̅_{base}, and a > 0.

If the magnetic field signal modulus of the selected magnetic sensor is the greatest, the magnetic sensor is taken as the magnetic sensor Y (because it is used as the end position of the basic displacement increment later), and a magnetic sensor with a smallest magnetic field signal modulus is determined as the magnetic sensor X. The current position where the magnetic sensor Y is located is taken as the initial position of the basic displacement increment, and the current position where the magnetic sensor X is located is taken as the end position of the basic displacement increment. The vector pointing from the initial position of the basic displacement increment to the end position of the basic displacement increment is taken as the basic displacement increment, and a negative adjustable coefficient is multiplied by the basic displacement increment to obtain the target displacement increment. Because the negative adjustable coefficient reverses a direction of the displacement increment, changing from originally Y pointing to X to X pointing to Y, when moving, the magnetic sensor X is still moved from the current position to the position of the magnetic sensor Y For a specific example, if chip 3 in the 36 sensors is selected as the fixed sensor at the initial position of the basic increment, and when the end position of the basic increment is selected, chip 3 is also the greatest magnetic field value, a minimum magnetic field chip, for example 6, is selected at this moment, at this moment, there is a vector pointing from chip 3 to chip 6, and the desired target displacement increment is obtained by multiplying the vector by the adjustable coefficient 1.

Manner 2, an average value of the magnetic field signals collected by all the magnetic sensors in the 36 magnetic sensors is obtained. A magnetic sensor, with a magnetic field signal the closest to the obtained average value of the magnetic field signals, in the 36 magnetic sensors is selected, and recorded as the magnetic sensor X, and the current position of the magnetic sensor X is taken as the initial position of the basic displacement increment. The magnetic sensor Y, having the greatest magnetic field signal modulus, in the M magnetic sensors is selected, and the current position where the magnetic sensor Y is located is taken as the end position of the basic displacement increment. The vector pointing from the initial position of the basic displacement increment to the end position of the basic displacement increment is taken as the basic displacement increment :Δ̅ϕ̅_{base2}, and the positive adjustable coefficient a is multiplied by the basic displacement increment to obtain the target displacement increment Δ̅ϕ̅₂, wherein Δ̅ϕ̅₂ = a × Δ̅ϕ̅_{base2}, and a > 0.

### (c) The manner of adopting the auxiliary magnetic sensor array to search for the position of the mobile magnetic source

This manner requires addition of the auxiliary magnetic sensor array. Magnetic sensors in the auxiliary magnetic sensor array have a large distribution space and may perform detection in the entire movement space of the mobile magnetic source, as shown in Fig. 1(b). Chips of the auxiliary magnetic sensor array are arranged according to a certain rule, and preferably may be installed under the working space of the mobile magnetic source, so effective position and posture detection of the mobile magnetic source may be performed. The advantage is that the position to establish the magnetic connection can be found directly, and then the magnetic connection is directly established. However, additional devices increase the extra cost of a system, the amount of calculation is large, and complex calculations are required for the collected magnetic fields.

The specific implementation process of this manner is:
Step c1, the auxiliary magnetic sensor array and an auxiliary signal processing circuit are used to collect the magnetic field signal of the mobile magnetic source, and position and posture detection is performed to obtain the position of the mobile magnetic source. The specific steps are as follows.

First, the auxiliary magnetic sensor array is used to measure the effective magnetic field signal:
(1) A driving magnetic field is prepared.
   The mobile magnetic source is removed, the driving magnet is moved to have a different position and posture relative to the auxiliary magnetic sensor array, and a driving magnetic field signal is stored as background magnetic field data.
(2) The array reads the magnetic field signals.
   The driving magnet is placed at an initial fixed position, or directly stops moving, and the magnetic field intensity at this moment is measured with the auxiliary magnetic sensor array. The magnetic field includes a magnetic field of the mobile magnetic source and a background noise signal.
(3) A background magnetic field signal is removed.

The sum of the magnetic field signals in the previous step is measured, and the background noise signal stored or calculated in step (1), namely signals generated by the geomagnetism and the driving magnet respectively and other interference signals, is subtracted from the total magnetic field to obtain the effective magnetic field signal.

Secondly, after the effective magnetic field signal is obtained, the effective magnetic field signal is used to perform arithmetic operations to obtain position and posture data based on an array coordinate system. Then coordinate system conversion is performed to obtain finally required position and posture data of the mobile magnetic source in the coordinate system.

Step c2, the target position of the movement guide module is determined. A specific manner is as follows: First, according to the relative distance requirements of detection and driving of the mobile magnetic source, the relative distance Δd between the movement guide module and the mobile magnetic source is predetermined, which is set here as 12 cm. Secondly, after the position of the mobile magnetic source is obtained, the position of the mobile magnetic source plus the predetermined relative distance Δd is the target position of the movement guide module.

Step c3, the movement guide module is moved to the target position, and the magnetic connection is established.

In order to implement the above method, the present invention further provides an apparatus for establishing an effective magnetic connection. As shown in Fig. 5, the apparatus for establishing the effective magnetic connection includes an effective magnetic connection judgment unit, an effective magnetic connection establishment unit, a magnetic sensor array signal obtaining unit and a movement guide module.

The magnetic sensor array signal obtaining unit is configured to obtain magnetic field signals collected by the magnetic sensor array, and send the magnetic field signals to the effective magnetic connection judgment unit and the effective magnetic connection establishment unit.

The movement guide module is configured to drive the driving magnet and the magnetic sensor array fixedly connected with the driving magnet to move according to movement requirements provided by the effective magnetic connection establishment unit.

The effective magnetic connection judgment unit is configured to judge whether the effective magnetic connection has been established according to the magnetic field signal intensity of a mobile magnetic source or a relative distance between the mobile magnetic source and the movement guide module.

The effective magnetic connection establishment unit includes a first establishment module and a second establishment module, and one of them is chosen for use.

The first establishment module divides a motion space of the driving magnet into a plurality of height planes, drives the magnetic sensor array to move through the movement guide module, searches for magnetic fields in the same height plane, and if a greatest magnetic field value meets a magnetic field establishment threshold of the effective magnetic connection, establishes the effective magnetic connection; and if not, searches for magnetic fields in another height plane until the condition is met.

The second establishment module obtains magnetic fields at different positions in a local space through the magnetic field signals collected by the magnetic sensor array, and if a greatest magnetic field value meets the magnetic field establishment threshold of the effective magnetic connection, establishes the effective magnetic connection; and if not, drives the magnetic sensor array to move through the movement guide module, changes a position of the local space according to conditions, and performs judgment again until the condition is met.

A process that the first establishment module performs searching according to height planes and establishes the connection is as follows.

With a position where the magnetic sensor array is located currently as a searching center, a plane region under a current height and with a set side length value is established as a searching region. A plurality of positions are designated as designated sampling positions of the magnetic sensor array. A magnetic sensor A is selected in the magnetic sensor array, and a magnetic field signal collected by the magnetic sensor A is taken as a signal source.

The magnetic sensor array is driven by the movement guide module to move, so the magnetic sensor A sequentially collects magnetic field signals at the designated sampling positions.

Magnetic field signal moduli collected by the magnetic sensor A at all the designated sampling positions in the current searching region are compared. If all the moduli are less than a set magnetic field modulus threshold, a height of the searching plane is decreased, and searching is performed again. Or, the movement guide module drives the magnetic sensor array to move, so the magnetic sensor A moves to a sampling position where a greatest magnetic field signal modulus appears, that is, the effective magnetic connection is established.

A process that the second establishment module performs searching according to a local region and establishes the connection is as follows.

M magnetic sensors for searching in the magnetic sensor array are selected, and magnetic field signals collected at a current position of the magnetic sensor array are obtained through the magnetic sensor array signal obtaining unit. M is an integer greater than or equal to 2.

A target displacement increment of the magnetic sensor array is determined according to the collected magnetic field signals. The target displacement increment is that a position of a magnetic sensor X in the M magnetic sensors points to a position of a magnetic sensor Y in the M magnetic sensors. The magnetic sensor Y is the one that obtains a greatest magnetic field signal in the M magnetic sensors.

With the position where the magnetic sensor array is located currently as a start point, the magnetic sensor array is driven by the movement guide module to move according to the target displacement increment, so the magnetic sensor X moves to the position of the magnetic sensor Y, thereby reaching the target position.

Effective magnetic connection judgment is performed based on the magnetic field signal intensity of the magnetic sensor X. If the effective magnetic connection has been established, the magnetic sensor array stops moving. If the effective magnetic connection has not been established, with the current target position as a start point, searching is performed again until the effective magnetic connection is established.

In another embodiment, the apparatus further includes an auxiliary magnetic sensor array module, including an auxiliary magnetic sensor array and an auxiliary signal processing circuit which are connected. The effective magnetic connection establishment unit further includes a third establishment module, configured to obtain a position of the mobile magnetic source according to detection of the auxiliary magnetic sensor array module, determine a target position of the movement guide module according to requirements of the relative distance between the mobile magnetic source and the driving magnet, and move the movement guide module to the target position to establish the effective magnetic connection. One of the first establishment module, the second establishment module, and the third establishment module is selected for use.

The effective magnetic connection judgment unit may use the auxiliary magnetic sensor array module to realize detection of the relative distance between the driving magnet and the mobile magnetic source.

In summary, the above are only preferable embodiments of the present invention, and are not used to limit the protection scope of the present invention. Any modification, equivalent replacement, improvement, etc. made within the spirit and principle of the present invention should fall within the protection scope of the present invention.

## Claims

1. A method for establishing an effective magnetic connection, **characterized by** being suitable for a case where a driving magnet and a magnetic sensor array are fixedly connected and a movement guide module is connected with the driving magnet and the magnetic sensor array for movement; and comprising a step of effective magnetic connection judgment and a step of effective magnetic connection establishment:
the effective magnetic connection judgment is: judging whether the effective magnetic connection has been established according to the magnetic field signal intensity of a mobile magnetic source or a relative distance Δd between the mobile magnetic source and the movement guide module;
the effective magnetic connection establishment is: establishing the connection in one of the following manners:
Manner 1: dividing a motion space of the driving magnet into a plurality of height planes, searching for magnetic fields in the same height plane, and if a greatest magnetic field value meets a magnetic field establishment threshold of the effective magnetic connection, establishing the effective magnetic connection; and if not, searching for magnetic fields in another height plane until the condition is met;
Manner 2: obtaining magnetic fields at different positions in a local space, if a greatest magnetic field value meets the magnetic field establishment threshold of the effective magnetic connection, establishing the effective magnetic connection; and if not, changing the local space according to conditions, and performing judgment again until the condition is met; and
Manner 3: using an auxiliary magnetic sensor array to obtain a position of the mobile magnetic source through detection, determining a target position of the movement guide module according to requirements for the relative distance Δd between the mobile magnetic source and the movement guide module, and moving the movement guide module to the target position to establish the effective magnetic connection.

2. The method of claim 1, **characterized in that** the manner of judging whether the effective magnetic connection has been established according to the magnetic field signal intensity of the mobile magnetic source is: collecting, by the magnetic sensor array, magnetic field signals of the mobile magnetic source, and if a magnetic field signal collected by a designated magnetic sensor in the magnetic sensor array is greater than a set magnetic field threshold of the effective magnetic connection, determining that the effective magnetic connection has been established; or, determining that the effective magnetic connection has not been established; and
the manner of judging whether the effective magnetic connection has been established according to the relative distance between the mobile magnetic source and the movement guide module is: detecting the relative distance between the mobile magnetic source and the movement guide module, and if the relative distance is less than a set relative distance threshold, determining that the effective magnetic connection has been established; or, determining that the effective magnetic connection has not been established.

3. The method of claim 1, **characterized in that** Manner 1 is specifically:
Step a1, with a position where the magnetic sensor array is located currently as a searching center, establishing a plane region under a current height and with a set side length value as a searching region; designating a plurality of positions as designated sampling positions of the magnetic sensor array; and selecting a magnetic sensor A in the magnetic sensor array, and using a magnetic field signal collected by the magnetic sensor A as a signal source;
Step a2, using the movement guide module to drive the magnetic sensor array to move, so the magnetic sensor A sequentially collects magnetic field signals at the designated sampling positions; and
Step a3, comparing magnetic field signal moduli collected by the magnetic sensor A at all the designated sampling positions in the current searching region; if all the moduli are less than a set magnetic field modulus threshold, decreasing a height of the searching plane, returning to Step a2 and searching again; or driving, by the movement guide module, the magnetic sensor array to move, so the magnetic sensor A moves to a sampling position where a greatest magnetic field signal modulus appears, that is, the effective magnetic connection is established.

4. The method of claim 1, **characterized in that** Manner 2 is specifically:
Step b1, selecting M magnetic sensors for searching in the magnetic sensor array, and collecting magnetic field signals at a current position of the magnetic sensor array, wherein M is an integer greater than or equal to 2;
Step b2: determining a target displacement increment of the magnetic sensor array according to the collected magnetic field signals, wherein the target displacement increment is that a position of a magnetic sensor X in the M magnetic sensors points to a position of a magnetic sensor Y in the M magnetic sensors; and the magnetic sensor Y is the one that obtains a greatest magnetic field signal in the M magnetic sensors;
Step b3, with the position where the magnetic sensor array is located currently as a start point, using the guide module to drive the magnetic sensor array to move according to the target displacement increment, so the magnetic sensor X moves to the position of the magnetic sensor Y, thereby reaching the target position; and
Step b4, performing the effective magnetic connection judgment based on the magnetic field signal intensity of the magnetic sensor X; if the effective magnetic connection has been established, stopping moving the magnetic sensor array; and if the effective magnetic connection has not been established, with the current target position as a start point, returning to Step b2 and performing searching again until the effective magnetic connection is established.

5. The method of claim 4, **characterized in that** a determining manner of the target displacement increment is:
selecting one magnetic sensor in the M magnetic sensors, and if a magnetic field signal modulus of the selected magnetic sensor is not the greatest, taking the magnetic sensor as the magnetic sensor X and a current position of the magnetic sensor as an initial position of a basic displacement increment; selecting the magnetic sensor Y, having a greatest magnetic field signal modulus, in the M magnetic sensors, and taking a current position where the magnetic sensor Y is located as an end position of the basic displacement increment; taking a vector pointing from the initial position of the basic displacement increment to the end position of the basic displacement increment as the basic displacement increment, and multiplying a positive adjustable coefficient by the basic displacement increment to obtain the target displacement increment; if the magnetic field signal modulus of the selected magnetic sensor is the greatest, using the magnetic sensor as the magnetic sensor Y and determining a magnetic sensor with a smallest magnetic field signal modulus as the magnetic sensor X; taking the current position where the magnetic sensor Y is located as the initial position of the basic displacement increment, and the current position where the magnetic sensor X is located as the end position of the basic displacement increment, taking the vector pointing from the initial position of the basic displacement increment to the end position of the basic displacement increment as the basic displacement increment, and multiplying a negative adjustable coefficient by the basic displacement increment to obtain the target displacement increment; or
obtaining an average value of the magnetic field signals collected by all the magnetic sensors in the M magnetic sensors; selecting a magnetic sensor, with a magnetic field signal the closest to the obtained average value of the magnetic field signals, in the M magnetic sensors, recording the magnetic sensor as the magnetic sensor X, and taking the current position of the magnetic sensor X as the initial position of the basic displacement increment; selecting the magnetic sensor Y, having the greatest magnetic field signal modulus, in the M magnetic sensors, and taking the current position where the magnetic sensor Y is located as the end position of the basic displacement increment; and taking the vector pointing from the initial position of the basic displacement increment to the end position of the basic displacement increment as the basic displacement increment, and multiplying the positive adjustable coefficient by the basic displacement increment to obtain the target displacement increment.

6. The method of claim 1, **characterized in that** the effective magnetic connection judgment is performed periodically, and when it is determined that the effective connection has not been established, the effective magnetic connection establishment operation is performed.

7. An apparatus for establishing an effective magnetic connection, **characterized by** being suitable for a case where a driving magnet is fixedly connected with a magnetic sensor array and a movement guide module is connected with the driving magnet and the magnetic sensor array for movement; and comprising an effective magnetic connection judgment unit, an effective magnetic connection establishment unit, a magnetic sensor array signal obtaining unit and the movement guide module;
the magnetic sensor array signal obtaining unit is configured to obtain magnetic field signals collected by the magnetic sensor array, and send the magnetic field signals to the effective magnetic connection judgment unit and the effective magnetic connection establishment unit;
the movement guide module is configured to drive the driving magnet and the magnetic sensor array fixedly connected with the driving magnet to move according to movement requirements provided by the effective magnetic connection establishment unit;
the effective magnetic connection judgment unit is configured to judge whether the effective magnetic connection has been established according to the magnetic field signal intensity of a mobile magnetic source or a relative distance Δd between the mobile magnetic source and the movement guide module;
the effective magnetic connection establishment unit comprises a first establishment module and a second establishment module, and one of them is chosen for use:
the first establishment module divides a motion space of the driving magnet into a plurality of height planes, drives the magnetic sensor array to move through the movement guide module, searches for magnetic fields in the same height plane, and if a greatest magnetic field value meets a magnetic field establishment threshold of the effective magnetic connection, establishes the effective magnetic connection; and if not, searches for magnetic fields in another height plane until the condition is met; and
the second establishment module obtains magnetic fields at different positions in a local space through the magnetic field signals collected by the magnetic sensor array, and if a greatest magnetic field value meets the magnetic field establishment threshold of the effective magnetic connection, establishes the effective magnetic connection; and if not, drives the magnetic sensor array to move through the movement guide module, changes a position of the local space according to conditions, and performs judgment again until the condition is met.

8. The apparatus of claim 7, **characterized by** further comprising an auxiliary magnetic sensor array;
the effective magnetic connection establishment unit further comprises a third establishment module configured to obtain a position of the mobile magnetic source according to detection of the auxiliary magnetic sensor array, determine a target position of the movement guide module according to requirement of the relative distance Δd between the mobile magnetic source and the movement guide module, and move the movement guide module to the target position to establish the effective magnetic connection; and one of the first establishment module, the second establishment module, and the third establishment module is selected for use.

9. The apparatus of claim 7, **characterized in that** a process that the first establishment module performs searching according to height planes and establishes the connection is as follows:
with a position where the magnetic sensor array is located currently as a searching center, establishing a plane region under a current height and with a set side length value as a searching region; designating a plurality of positions as designated sampling positions of the magnetic sensor array; and selecting a magnetic sensor A in the magnetic sensor array, and using a magnetic field signal collected by the magnetic sensor A as a signal source;
using the movement guide module to drive the magnetic sensor array to move, so the magnetic sensor A sequentially collects magnetic field signals at the designated sampling positions; and
comparing magnetic field signal moduli collected by the magnetic sensor A at all the designated sampling positions in the current searching region; if all the moduli are less than a set magnetic field modulus threshold, decreasing a height of the searching plane, and searching again; or driving, by the movement guide module, the magnetic sensor array to move, so the magnetic sensor A moves to a sampling position where a greatest magnetic field signal modulus appears, that is, the effective magnetic connection is established.

10. The apparatus of claim 7, **characterized in that** a process that the second establishment module performs searching according to a local region and establishes the connection is as follows:
selecting M magnetic sensors for searching in the magnetic sensor array, and obtaining magnetic field signals collected at a current position of the magnetic sensor array through the magnetic sensor array signal obtaining unit, wherein M is an integer greater than or equal to 2;
determining a target displacement increment of the magnetic sensor array according to the collected magnetic field signals, wherein the target displacement increment is that a position of a magnetic sensor X in the M magnetic sensors points to a position of a magnetic sensor Y in the M magnetic sensors; and the magnetic sensor Y is the one that obtains a greatest magnetic field signal in the M magnetic sensors;
with the position where the magnetic sensor array is located currently as a start point, using the movement guide module to drive the magnetic sensor array to move according to the target displacement increment, so the magnetic sensor X moves to the position of the magnetic sensor Y, thereby reaching the target position; and
performing effective magnetic connection judgment based on the magnetic field signal intensity of the magnetic sensor X; if the effective magnetic connection has been established, stopping moving the magnetic sensor array; and if the effective magnetic connection has not been established, with the current target position as a start point, performing searching again until the effective magnetic connection is established.
